(19) Europäisches Patentamt / European Patent Office / Office européen des brevets

(11) **EP 4 535 551 A1**

## EUROPEAN PATENT APPLICATION
published in accordance with Art. 153(4) EPC

(43) Date of publication:
**09.04.2025 Bulletin 2025/15**

(21) Application number: **23811235.3**

(22) Date of filing: **23.05.2023**

(51) International Patent Classification (IPC):
*H01M 50/569* (2021.01)    *H01M 10/48* (2006.01)
*H01M 50/211* (2021.01)    *H01M 50/296* (2021.01)
*H01M 50/298* (2021.01)    *H01M 50/50* (2021.01)
*H01M 50/505* (2021.01)    *H02J 7/00* (2006.01)

(52) Cooperative Patent Classification (CPC):
**H01M 10/48; H01M 50/211; H01M 50/296;
H01M 50/298; H01M 50/50; H01M 50/505;
H01M 50/569; H02J 7/00;** Y02E 60/10

(86) International application number:
**PCT/IB2023/000279**

(87) International publication number:
**WO 2023/227939 (30.11.2023 Gazette 2023/48)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **25.05.2022 JP 2022085496**

(71) Applicants:
• **NISSAN MOTOR CO., LTD.
Kanagawa 221-0023 (JP)**

• **Renault s.a.s
92100 Boulogne Billancourt (FR)**

(72) Inventor: **SAKAI, Masanobu
Atsugi-shi, Kanagawa 243-0123 (JP)**

(74) Representative: **Grünecker Patent- und
Rechtsanwälte
PartG mbB
Leopoldstraße 4
80802 München (DE)**

(54) **BATTERY MODULE**

(57)    A battery module including: a laminated cell in which a plurality of battery cells are laminated; a bus bar connected to the battery cells; and a sensor unit including a sensor circuit that is electrically connected to the bus bar and that measures a state of the battery cells, wherein the bus bar is disposed in an accommodation space formed on one side surface of the laminated cell, the sensor unit includes a sensor case accommodating the sensor circuit, formed to match a shape of the bus bar, and accommodated in the accommodation space in a manner of being in contact with the bus bar, and a fitting portion electrically connected to the sensor circuit, disposed at a position facing the bus bar in the sensor case when the sensor case is accommodated in the accommodation space, and capable of being fitted to the bus bar, and by fitting the fitting portion to the bus bar, the sensor case is fixed to the bus bar, and the sensor circuit is electrically connected to the bus bar via the fitting portion.

EP 4 535 551 A1

**(Cont. next page)**

FIG.3

**Description**

TECHNICAL FIELD

The present invention relates to a battery module.

BACKGROUND ART

JP 2021-18133 A discloses a configuration in which a sensor unit that monitors a state of battery cells is attached to a laminated cell in which a plurality of the battery cells are laminated.

SUMMARY OF INVENTION

However, in JP 2021-18133 A, when the sensor unit and the laminated cell are attached, a wiring connection work of connecting a wiring of the sensor unit to an electrode of the laminated cell is required, and the number of parts and the number of assembly steps are increased. Further, a wiring removal work at the time of reusing/recycling becomes complicated. In the wiring connection work and the wiring removal work, a method for preventing a short circuit of the laminated cell is required. Further, in the case in which the sensor unit is designed to be optimized for an in-vehicle use, it is necessary to attach a sensor unit having a new specification when the laminated cell is separated and reused for a secondary use of the battery cells, but at that time the above problem occurs again.

An object of the present invention is to provide a battery module in which a sensor unit can be attached to a laminated cell while avoiding complicated wiring connection work and wiring removal work and a short circuit prevention measure.

A battery module according to the present invention is a battery module including: a laminated cell in which a plurality of battery cells are laminated; a bus bar connected to the battery cells; and a sensor unit including a sensor circuit that is electrically connected to the bus bar and that measures a state of the battery cells. In the battery module, the bus bar is disposed in an accommodation space formed on one side surface of the laminated cell, the sensor unit includes a sensor case accommodating the sensor circuit, formed to match a shape of the bus bar, and accommodated in the accommodation space in a manner of being in contact with the bus bar, and a fitting portion electrically connected to the sensor circuit, disposed at a position facing the bus bar in the sensor case when the sensor case is accommodated in the accommodation space, and capable of being fitted to the bus bar. Further, by fitting the fitting portion to the bus bar, the sensor case is fixed to the bus bar, and the sensor circuit is electrically connected to the bus bar via the fitting portion.

BRIEF DESCRIPTION OF DRAWINGS

[FIG. 1] FIG. 1 is a perspective view of a laminated cell constituting a battery module according to the present embodiment.
[FIG. 2] FIG. 2 is a view showing a region where a sensor unit and the like can be attached in an accommodation space formed in the laminated cell.
[FIG. 3] FIG. 3 is an exploded perspective view of the battery module according to the present embodiment.
[FIG. 4A] FIG. 4A is a perspective view of the sensor unit constituting the battery module according to the present embodiment.
[FIG. 4B] FIG. 4B is a cross-sectional view of the sensor unit constituting the battery module according to the present embodiment.
[FIG. 5] FIG. 5 is a cross-sectional view showing a connection state of the sensor unit.
[FIG. 6] FIG. 6 is a partial detailed view of FIG. 5.
[FIG. 7] FIG. 7 is a circuit diagram of the sensor unit, battery cells, a positive electrode bus bar, a negative electrode bus bar, and an intermediate bus bar.
[FIG. 8] FIG. 8 is a perspective view of a first modification of the battery module according to the present embodiment.
[FIG. 9A] FIG. 9A is a plan view of a sensor power supply unit according to the first modification.
[FIG. 9B] FIG. 9B is a cross-sectional view before the sensor power supply unit according to the first modification is sandwiched between a positive electrode bus bar and a negative electrode bus bar.
[FIG. 9C] FIG. 9C is a cross-sectional view after the sensor power supply unit according to the first modification is sandwiched between the positive electrode bus bar and the negative electrode bus bar.
[FIG. 9D] FIG. 9D is a cross-sectional view when the sensor power supply unit according to the first modification is fixed by a clip.

[FIG. 10] FIG. 10 is a circuit diagram of the sensor unit, the battery cells, the positive electrode bus bar, the negative electrode bus bar, the intermediate bus bar, and the sensor power supply unit according to the first modification.

[FIG. 11] FIG. 11 is a view illustrating an example of a jumper wire extending from the sensor unit.

[FIG. 12] FIG. 12 is a view showing an example of the clip attached to a sensor case.

[FIG. 13] FIG. 13 is a circuit diagram of the sensor unit, the battery cells, the positive electrode bus bar, the negative electrode bus bar, and the intermediate bus bar according to a second modification of the battery module of the present embodiment.

DESCRIPTION OF EMBODIMENTS

Hereinafter, an embodiment of the present invention will be described with reference to the accompanying drawings.

[Configuration of Laminated Cell 1]

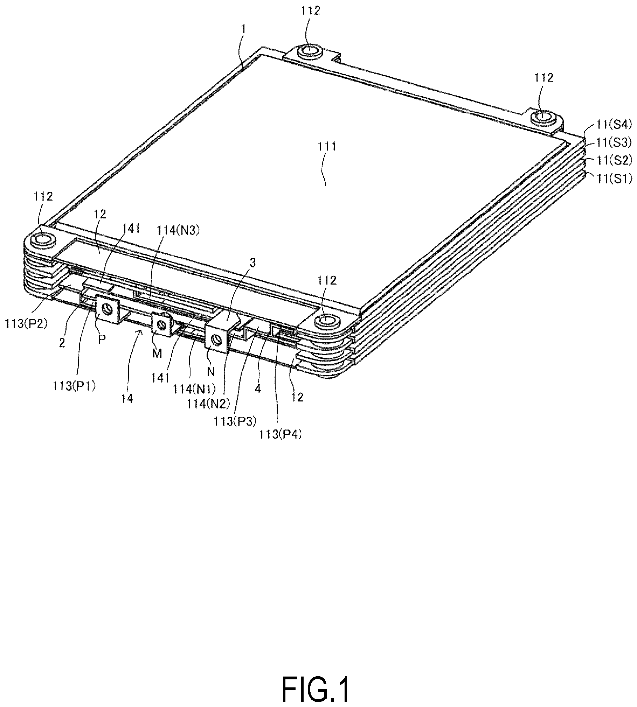

FIG. 1 is a perspective view of a laminated cell 1 constituting a battery module according to the present embodiment. In the present embodiment, the laminated cell 1 is formed by laminating a plurality of (for example, four) battery cells 11 (S1, S2, S3, S4). The battery cell 11 includes a power storage unit 111 formed by, for example, a lithium ion battery or the like, and fastening portions 112 disposed at both ends of each of two long sides (or short sides) of the power storage unit 111. Further, the laminated cell 1 is formed by laminating the battery cells 11 and fastening the fastening portions 112 by, for example, crimping.

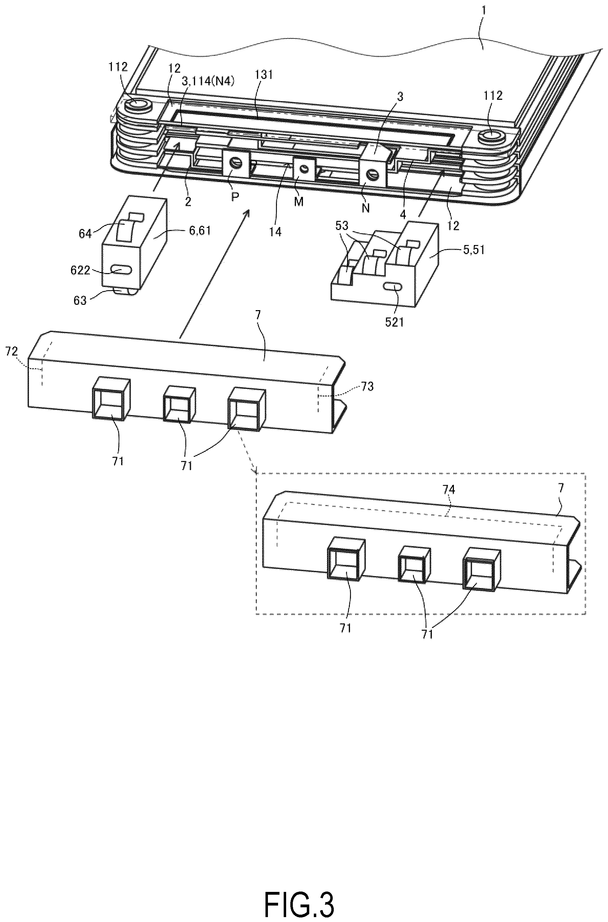

Thin plate portions 12 are disposed at positions sandwiched between the two fastening portions 112 in the battery cells 11 at both ends in a thickness direction in the laminated cell 1. Further, a region surrounded by the fastening portion 112 and the thin plate portion 12 serves as an accommodation space 14 in which a positive electrode bus bar 2, a negative electrode bus bar 3, an intermediate bus bar 4, a sensor unit 5 (FIG. 3), and the like to be described later are accommodated.

The battery cell 11 includes a positive electrode cell tab 113 extending from a positive electrode of the power storage unit 111 and disposed in the accommodation space 14, and a negative electrode cell tab 114 extending from a negative electrode of the power storage unit 111 and disposed in the accommodation space 14.

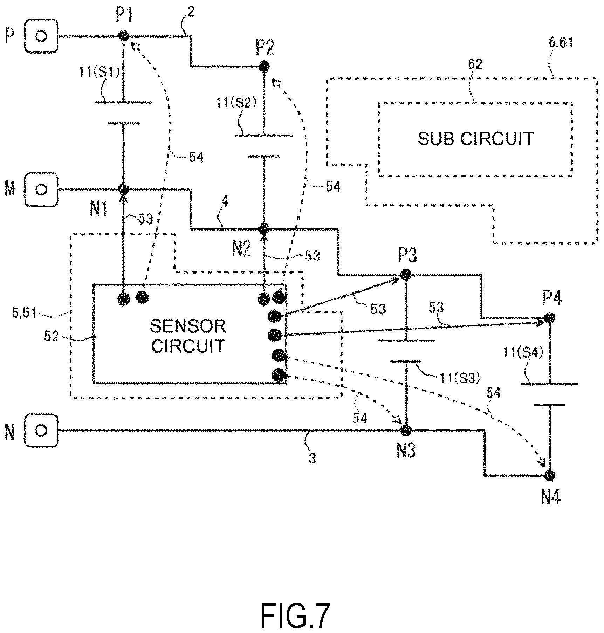

The positive electrode bus bar 2 includes a positive electrode external terminal P connected to an outside, and is connected to a positive electrode cell tab 113 (P1) of the bottom battery cell 11 (S1) shown in FIG. 1 and a positive electrode cell tab 113 (P2) of the second battery cell 11 (S2) from the bottom in order of electrical proximity from the positive electrode external terminal P (FIG. 7). Further, the positive electrode bus bar 2 is supported by the positive electrode cell tab 113 (P1) and the positive electrode cell tab 113 (P2).

The negative electrode bus bar 3 includes a negative electrode external terminal N connected to the outside, and is connected to a negative electrode cell tab 114 (N3) of the second battery cell 11 (S3) from the top shown in FIG. 1 and a negative electrode cell tab 114 (N4) (not shown in FIG. 1, see FIG. 3) of the uppermost battery cell 11 (S4) in order of electrical proximity from the negative electrode external terminal N (FIG. 7). Further, the negative electrode bus bar 3 is supported by the negative electrode cell tab 114 (N3) and the negative electrode cell tab 114 (N4).

The intermediate bus bar 4 has an intermediate external terminal M connected to the outside, and is connected to a negative electrode cell tab 114 (N1) of the battery cell 11 (S1), a negative electrode cell tab 114 (N2) of the battery cell 11 (S2), a positive electrode cell tab 113 (P3) of the battery cell 11 (S3), and a positive electrode cell tab 113 (P4) of the battery cell 11 (S4) in order of electrical proximity from the intermediate external terminal M (FIG. 7). Further, the intermediate bus bar 4 is supported by the negative electrode cell tab 114 (N1), the negative electrode cell tab 114 (N2), the positive electrode cell tab 113 (P3), and the positive electrode cell tab 113 (P4).

In the above connection configuration, a positive electrode of the battery cell 11 (S1) and a positive electrode of the battery cell 11 (S2) are connected in parallel to the positive electrode bus bar 2, and the positive electrode of the battery cell 11 (S1) and the positive electrode of the battery cell 11 (S2) are a positive electrode of the laminated cell 1 (FIG. 7). A negative electrode of the battery cell 11 (S3) and a negative electrode of the battery cell 11 (S4) are connected in parallel to the negative electrode bus bar 3, and the negative electrode of the battery cell 11 (S3) and the negative electrode of the battery cell 11 (S4) are a negative electrode of the laminated cell 1 (FIG. 7). Further, a negative electrode of the battery cell 11 (S1), a negative electrode of the battery cell 11 (S2), a positive electrode of the battery cell 11 (S3), and a positive electrode of the battery cell 11 (S4) are connected in parallel to the intermediate bus bar 4 (FIG. 7).

The positive electrode bus bar 2, the negative electrode bus bar 3, and the intermediate bus bar 4 are bent stepwise in the accommodation space 14 so as not to be in contact with other bus bars while being connected to the respective cell tabs.

In the accommodation space 14, a stopper 141 is disposed close to the bus bars, and when the bus bars vibrate with respect to the laminated cell 1 due to external vibration, the bus bars are brought into preferential contact with the stopper 141 to prevent the bus bars from contacting other bus bars.

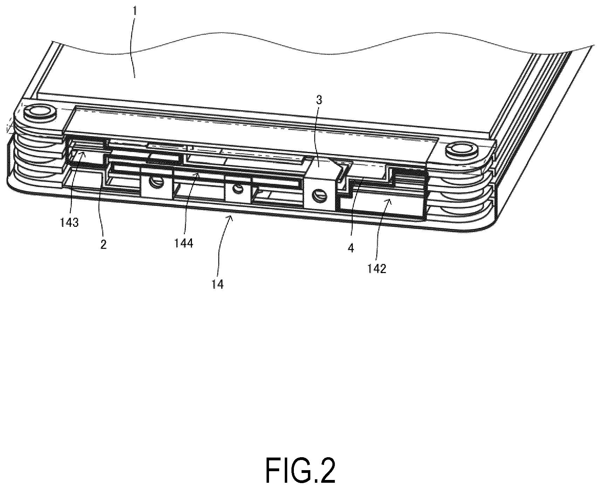

FIG. 2 is a view showing a region where the sensor unit 5 and the like can be attached in the accommodation space 14 formed in the laminated cell 1. As shown in FIG. 2, a plurality of divided spaces (first divided space 142, second divided space 143, and third divided space 144) (portions surrounded by thick lines) partitioned by the positive electrode bus bar 2, the negative electrode bus bar 3, and the intermediate bus bar 4 are formed in the accommodation space 14. In the present embodiment, the sensor unit 5 to be described later is disposed in the first divided space 142, but can also be disposed in the second divided space 143 and the third divided space 144.

For example, when the accommodation space 14 is divided by bus bars (positive electrode bus bar 2, negative electrode bus bar 3, and intermediate bus bar 4) finely, the sensor unit 5 (sensor circuit 52 to be described later) is divided into a plurality of divided sensor units, divided sensor cases (sensor cases 51 to be described later) as many as the divided sensor units 5 are prepared, and divided sensor circuits (sensor circuits 52 to be described later) are accommodated in the respective divided sensor cases (sensor cases 51) and are disposed in the accommodation space 14. Accordingly, even if the plurality of divided sensor cases (sensor cases 51) are present, the divided sensor cases each having a small size are provided in the accommodation space 14, and thus the divided sensor cases can be disposed so as not to interfere with the bus bars, and a degree of freedom in designing the battery module can be increased.

[Configuration of Battery Module]

FIG. 3 is an exploded perspective view of the battery module according to the present embodiment. The battery module according to the present embodiment includes the laminated cell 1, the sensor unit 5, a sub circuit unit 6, and a terminal cover 7 (cover). In the battery module according to the present embodiment, the sensor unit 5 and the sub circuit unit 6 are disposed in the accommodation space 14, and the terminal cover 7 is fitted to a side surface of the laminated cell 1 so as to cover the accommodation space 14 (sensor unit 5 and sub circuit unit 6).

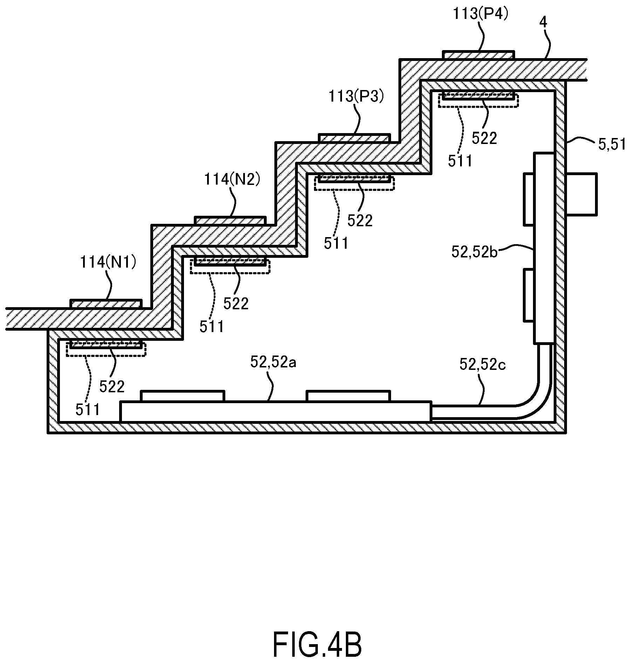

The sensor unit 5 is disposed, for example, in the first divided space 142 (FIG. 2) formed between the thin plate portion 12 and the intermediate bus bar 4 in the accommodation space 14, and includes the sensor case 51 having an outer shape that matches a shape of the first divided space 142, that is, a stepped shape of the intermediate bus bar 4. In FIG. 3, the number of steps of a surface of the sensor case 51 facing the intermediate bus bar 4 can be freely set according to the number of connections to cell tabs of the sensor circuit 52. The sensor case 51 may have at least a shape that can be fitted into the first divided space having a stepped shape partitioned by the intermediate bus bar 4. In the sensor case 51, for example, the sensor circuit 52 (FIG. 4B) that detects a state (output voltage and internal resistance) of the battery cell 11 is disposed.

First conductive clips 53 are disposed at positions of the sensor case 51 facing the respective steps (the cell tabs are disposed) of the intermediate bus bar 4. Each of the first clips 53 is a plate spring-shaped contact made of phosphor bronze, for example, and has an appropriate elastic force and electrical conduction resistance.

The first clip 53 is electrically connected to the sensor circuit 52 (FIG. 4B). Further, the sensor case 51 is fixed to the intermediate bus bar 4 (cell tab) by sandwiching the intermediate bus bar 4 (and cell tab) between the first clip 53 and the sensor case 51 and applying a pressing force of the first clip 53 to the intermediate bus bar 4, and the sensor circuit 52 and the intermediate bus bar 4 (cell tab) are electrically connected to each other via the first clip 53.

The outer shape of the sensor case 51 may be designed to be slightly larger than that of the first divided space 142 formed between the thin plate portion 12 and the intermediate bus bar 4, and the sensor case 51 may be disposed in the first divided space 142 in a manner of being pushed into the first divided space 142. Accordingly, the sensor case 51 is fixed to the first divided space 142 by the pressing force of the first clip 53 and a pressing force of the sensor case 51 against the intermediate bus bar 4, and thus a load on the first clip 53 can be reduced accordingly (the same applies to the sub circuit unit 6 to be described later).

A first connection terminal 521 is disposed on a surface of the sensor case 51 facing the terminal cover 7. The first connection terminal 521 is used as, for example, a power supply input terminal that supplies power to the sensor circuit 52, a terminal that performs two-way communication with the sub circuit unit 6, or the like. The first connection terminal 521 is disposed so as to protrude from the sensor case 51 toward the terminal cover 7, and comes into contact with a second wiring 73 disposed on an inner wall of the terminal cover 7 when the terminal cover 7 is fitted into the laminated cell 1. It is preferable that the first connection terminal 521 has, for example, the same structure as that of the first clip 53, is deformed by receiving a pressing force from the terminal cover 7, and can apply a restoring force generated by the deformation to the terminal cover 7 (first wiring 72). Accordingly, electrical connection between the first connection terminal 521 and the first wiring 72 can be ensured.

The sub circuit unit 6 is disposed, for example, in the second divided space 143 (FIG. 2) formed between the positive electrode bus bar 2 and the negative electrode bus bar 3 in the accommodation space 14, and includes a circuit case 61 (corresponding to a holder 61a to be described later) having an outer shape that matches a shape of the second divided space 143.

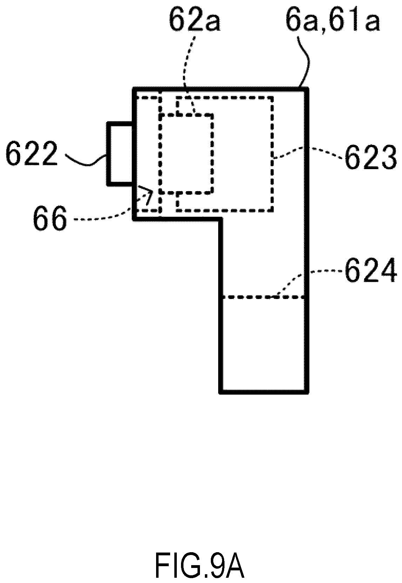

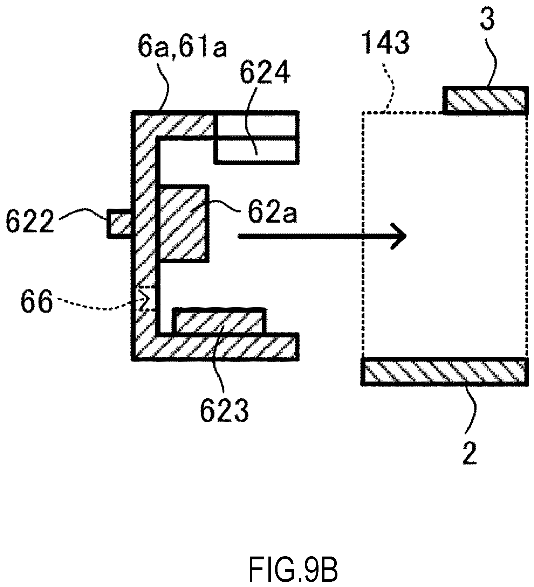

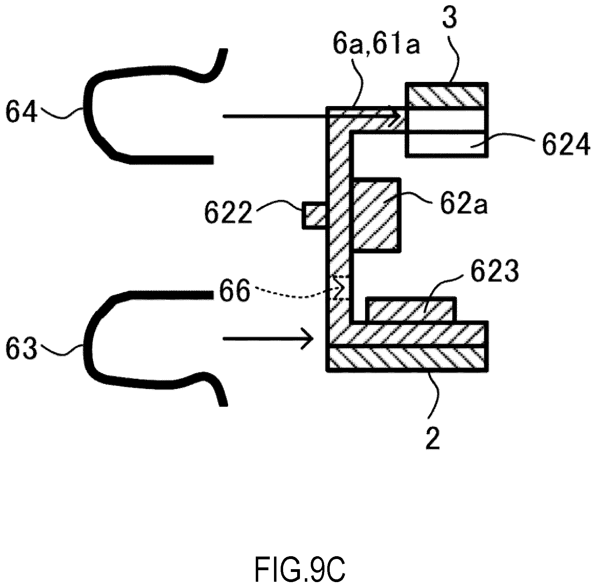

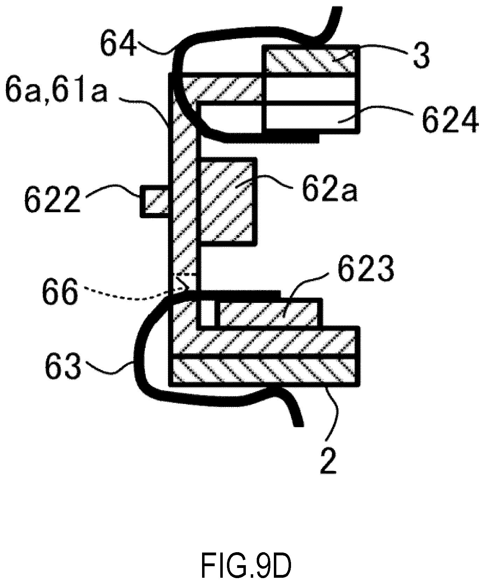

The sub circuit 62 (FIG. 7) disposed in the circuit case 61 is intended to support the sensor circuit 52, such as a sensor power supply circuit 62a (FIGS. 9A, 9B, 9C, and 9D) for supplying the power to the sensor unit 5, and a bluetooth (registered trademark) low energy (BLE)-type sensor communication circuit that allows information obtained by the sensor circuit 52 to communicate with the outside in both directions.

A second clip 63 is disposed at a position of the circuit case 61 facing the positive electrode bus bar 2, and a third clip 64 is disposed at a position of the circuit case 61 facing the negative electrode bus bar 3. The second clip 63 and the third clip 64 have the same structure as the first clip 53.

The second clip 63 is electrically connected to the sub circuit 62 (FIGS. 7, 9A, 9B, 9C, and 9D). The circuit case 61 is fixed to the positive electrode bus bar 2 by sandwiching the positive electrode bus bar 2 between the second clip 63 and the circuit case 61 and applying a pressing force of the second clip 63 to the circuit case 61 and the positive electrode bus bar 2, and the sub circuit 62 is electrically connected to the positive electrode bus bar 2 via the second clip 63.

Similarly to the second clip 63, the third clip 64 is electrically connected to the sub circuit 62 (FIGS. 7, 9A, 9B, 9C, and 9D). The circuit case 61 is fixed to the negative electrode bus bar 3 by sandwiching the negative electrode bus bar 3 between the third clip 64 and the circuit case 61 and applying a pressing force of the third clip 64 to the circuit case 61 and the negative electrode bus bar 3, and the sub circuit 62 is electrically connected to the negative electrode bus bar 3 via the third clip 64.

A second connection terminal 622 is disposed on a surface of the circuit case 61 facing the terminal cover 7. The second connection terminal 622 is used as, for example, a power supply output terminal that supplies power to the sensor circuit 52, a terminal that performs two-way communication with the sensor circuit 52, or the like.

The second connection terminal 622 has the same structure as that of the first connection terminal 521, is disposed in a manner of protruding from the circuit case 61 toward the terminal cover 7, and abuts against the first wiring 72 disposed on an inner wall of the terminal cover 7 when the terminal cover 7 is fitted into the laminated cell 1.

The terminal cover 7 is a member including the inner wall in contact with outer walls of the two thin plate portions 12 of the laminated cell 1. The terminal cover 7 is formed of, for example, an electrical insulating material having a magnetic action similarly to the sensor case 51 as described later, and includes a surface covered with an insulating layer (not shown) such as a resin.

By inserting the terminal cover 7 from an opening of the accommodation space 14, the terminal cover 7 is attached to the laminated cell 1 so as to cover the accommodation space 14.

Insertion holes 71 into which the positive electrode external terminal P, the negative electrode external terminal N, and the intermediate external terminal M are respectively inserted are disposed in the terminal cover 7, and when the terminal cover 7 is attached to the laminated cell 1, each external terminal is disposed in the insertion hole 71.

The first wiring 72 and the second wiring 73 are disposed on the insulating layer (not shown) on the inner wall of the terminal cover 7. On the other hand, on the outer wall of the thin plate portion 12, a third wiring 131 extending in a direction connecting the pair of fastening portions 112 and extending in a direction toward the first connection terminal 521 of the sensor case 51 in plan view at one of both ends thereof and in a direction toward the second connection terminal 622 of the sub circuit unit 6 at the other of the both ends is disposed. Each of the first wiring 72, the second wiring 73, and the third wiring 131 is formed of, for example, a copper (Cu) tape.

When the terminal cover 7 is attached to the laminated cell 1, one end of the first wiring 72 is disposed at a position facing the second connection terminal 622 and the other end is disposed at a position facing the third wiring 131.

When the terminal cover 7 is attached to the laminated cell 1, one end of the second wiring 73 is disposed at a position facing the first connection terminal 521 and the other end is disposed at a position facing the third wiring 131.

Accordingly, when the terminal cover 7 is attached to the laminated cell 1, one end of the first wiring 72 comes into contact with the second connection terminal 622 and the other end comes into contact with the third wiring 131. One end of the second wiring 73 comes into contact with the first connection terminal 521, and the other end is connected to the third wiring 131. Accordingly, the first connection terminal 521 and the second connection terminal 622 are electrically connected to each other via the first wiring 72, the second wiring 73, and the third wiring 131. The third wiring 131 may be omitted, and as shown in FIG. 3 (terminal cover 7 shown in a portion surrounded by a rectangular broken line), a fourth wiring 74 may be disposed on the inner wall of the terminal cover 7, in a manner that connects the first wiring 72 and the second wiring 73 to each other.

For example, when the sensor circuit 52 in the sensor unit 5 and the sub circuit 62 (FIGS. 7, 9A, 9B, 9C, and 9D) in the sub circuit unit 6 can perform two-way wireless communication, a small battery is built in the sensor circuit 52, and power supply from the outside is unnecessary, the first connection terminal 521, the second connection terminal 622, the first wiring 72, the second wiring 73, the third wiring 131, and the fourth wiring 74 can be omitted.

[Sensor Unit]

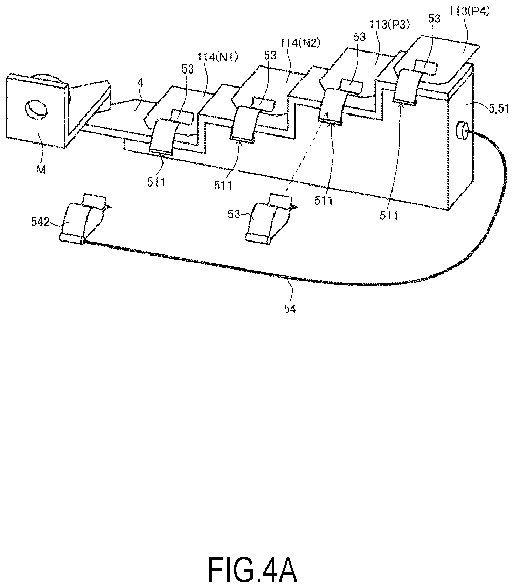

FIG. 4A is a perspective view of the sensor unit 5 constituting the battery module according to the present embodiment. FIG. 4B is a cross-sectional view of the sensor unit 5 constituting the battery module according to the present embodiment. FIG. 4A shows a state in which the sensor unit 5 is attached to the intermediate bus bar 4.

As shown in FIG. 4A, the intermediate bus bar 4 has a four-step shape, and the cell tab extending from the battery cell 11 is disposed in each step. The cell tabs disposed on the intermediate bus bar 4 are, for example, from the top in FIG. 4A, the positive electrode cell tab 113 (P4) of the battery cell 11 (S4), the positive electrode cell tab 113 (P3) of the battery cell 11 (S3), the negative electrode cell tab 114 (N2) of the battery cell 11 (S2), and the negative electrode cell tab 114 (N1) of the battery cell 11 (S1).

The sensor case 51 (the same applies to the circuit case 61) is formed of an electrical insulating material having a magnetic action, and can electrostatically shield an inside of the case.

Here, the sensor case 51 is made by sheet metal working or pressing a metal material having high magnetic permeability, such as an iron plate or a steel plate, or by die casting or hot pressing a resin mixed with a magnetic powder. Further, an insulating layer is formed by applying a resin or the like to an inner wall of the sensor case 51. Furthermore, the sensor case 51 may be made of a resin, and a magnetic paint may be applied to an outer wall thereof.

As the electrical insulating material having a magnetic action, for example, a high-performance soft magnetic powder (DAPM3, DAPMS7, DAPMSA10, DAPMSC, and the like) manufactured by Daido Steel Co., Ltd., a metallic glass magnetic powder (SAP-2D) and a metallic soft magnetic powder (FSC2K) manufactured by SINTOKOGIO, LTD., and a metal-based soft magnetic material (metallic flat powder, metal-based injection molding material, magnetic sheet) manufactured by Mate Co.,Ltd. can be applied.

Further, as shown in FIG. 4B, the sensor circuit 52 and extraction electrodes 522 extracted from the sensor circuit 52 are disposed in the sensor case 51. Each of the extraction electrodes 522 is formed by attaching copper foil (having an insulating layer on a sensor case 51 side) to the sensor case 51.

As shown in FIGS. 4A and 4B, an insertion hole 511 through which one arm of the first clip 53 is inserted is disposed in the sensor case 51.

As shown in FIG. 4A, the first clip 53 can be separated from the sensor case 51 in an initial state. Further, in a state in which two arms of the first clip 53 are slightly opened, the one arm is inserted into the insertion hole 511, and the other arm of the first clip 53 is brought into contact with the cell tab. Accordingly, the cell tabs (positive electrode cell tabs 113 and negative electrode cell tabs 114), the intermediate bus bar 4, the sensor case 51, and the extraction electrode 522 are simultaneously sandwiched by an elastic force in an arm closing direction of the first clip 53.

Accordingly, the sensor case 51 is fixed to the intermediate bus bar 4 by the first clip 53. Further, the extraction electrodes 522 of the sensor circuit 52 are electrically connected to the cell tabs (positive electrode cell tabs 113 and negative electrode cell tabs 114) via the first clips 53, respectively.

For example, the first clips 53 can be directly joined to the cell tabs (positive electrode cell tabs 113 and negative electrode cell tabs 114) by ultrasonic welding, respectively. This prevents the sensor circuit 52 from detecting a resistance component of the bus bar.

The sensor circuit 52 can be set to any shape, but for example, it is also preferable that two rigid substrates 52a and 52b are connected by a flexible substrate 52c and arranged in an L shape as shown in FIG. 4B. Further, the extraction electrode 522 may also be disposed on a flexible substrate connected to the substrate 52a or 52b, and the substrate may be disposed at a position facing the insertion hole 511.

Four jumper wires 54 (only one is shown in FIG. 4A) connected to the sensor circuit 52 extend from a side surface of the sensor case 51, and a fourth clip 542 (the same structure as the first clip 53 can be applied) is attached to a tip of the jumper wire 54. The fourth clips 542 sandwich respective the bus bars, for example, at a position where the positive electrode cell tab 113 (P1) of the battery cell 11 (S1) is disposed on the positive electrode bus bar 2, at a position where the positive electrode cell tab 113 (P2) of the battery cell 11 (S2) is disposed on the positive electrode bus bar 2, at a position where the negative electrode cell tab 114 (N3) of the battery cell 11 (S3) is disposed on the negative electrode bus bar 3, and at a position where the negative electrode cell tab 114 (N4) of the battery cell 11 (S4) is disposed on the negative electrode bus bar 3. Accordingly, the sensor circuit 52 is electrically connected to the cell tabs (positive electrode cell tabs 113 and negative electrode cell tabs 114) via the jumper wire 54 (fourth clip 542).

[Connection State of Sensor Unit 5]

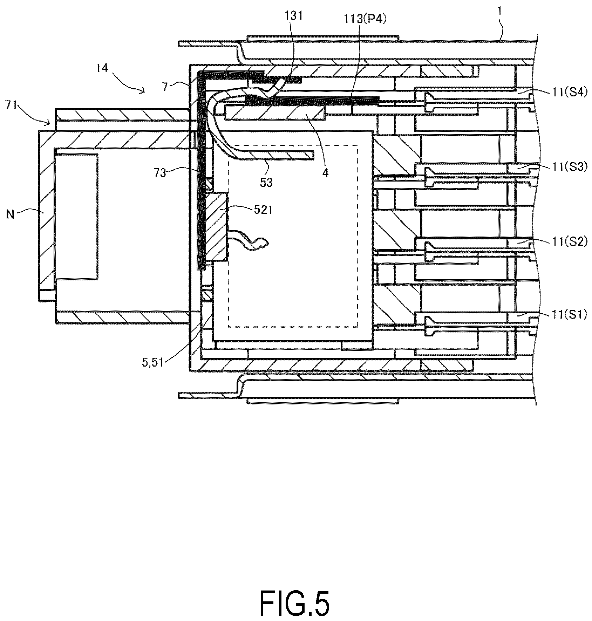

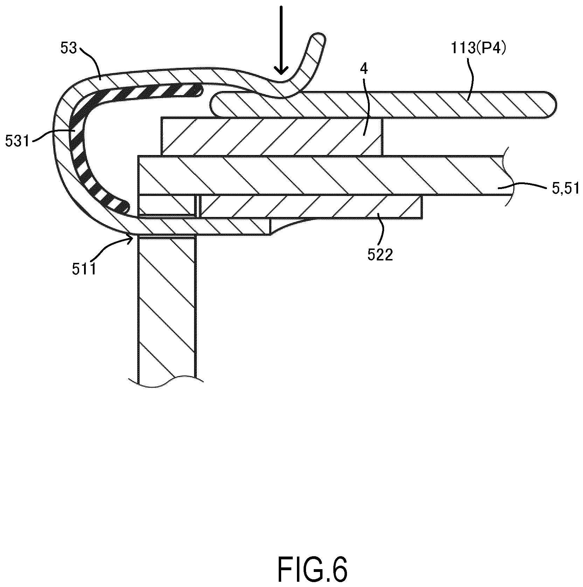

FIG. 5 is a cross-sectional view illustrating a connection state of the sensor unit 5. FIG. 6 is a partial detailed view of FIG. 5. As shown in FIG. 5, when the terminal cover 7 is attached to the laminated cell 1, each external terminal (negative electrode external terminal N in the figure) is disposed in the insertion hole 71 of the terminal cover 7.

The first connection terminal 521 disposed in the sensor case 51 is in contact with the second wiring 73, and the second wiring 73 is in contact with the third wiring 131. At this time, although not shown, the second connection terminal 622 disposed in the circuit case 61 is in contact with the first wiring 72.

As described above, the one of the arms of the first clip 53 is inserted into the insertion hole 511 formed in the sensor case 51 to sandwich respective one of the cell tabs (positive electrode cell tabs 113 and negative electrode cell tabs 114), the intermediate bus bar 4, the sensor case 51, and the extraction electrode 522 at the same time. At this time, the first clip 53 may come into contact with the bus bar. When the first clip 53 is in contact with the bus bar, a charge and discharge current also flows through the first clip 53, an excessive current may flow through the first clip 53, which is not designed to carry a large current, and the first clip 53 may become heated or be damaged. Or, a detection signal input to the sensor circuit 52 will contain a resistance component of the bus bar, which will lead to a sensor error.

Therefore, an insulating layer 531 is disposed on an inner wall of a portion of the first clip 53 exposed from the sensor case 51, excluding contact positions with the cell tabs (positive electrode cell tabs 113 and negative electrode cell tabs 114). The insulating layer 531 can be achieved by attaching an electrical insulating tape in which an electrical insulating layer is made of polyimide or the like, resin coating, or the like. This ensures electrical insulation between the first clip 53 and the bus bar.

Although not shown, an inner wall of the insertion hole 511 is also covered with an insulating layer. Accordingly, electrical insulation between the sensor case 51 and the first clip 53 can be ensured.

When the sensor unit 5 is attached to the intermediate bus bar 4, the first clip 53 may be joined to the extraction electrode 522 in advance by soldering or the like. Further, by pressing a horn (not shown), which ultrasonically vibrates, from the first clip 53 side to a contact position (arrow in FIG. 6) of the first clip 53 with the respective one of the cell tabs (positive electrode cell tabs 113 and the negative electrode cell tabs 114), the first clip 53, the respective one of the cell tabs (positive electrode cell tabs 113 and negative electrode cell tabs 114), and the intermediate bus bar 4 are mutually melted. Accordingly, the first clip 53 can be connected to the respective one of the cell tabs (positive electrode cell tabs 113 and negative electrode cell tabs 114), and the cell tabs (positive electrode cell tabs 113 and negative electrode cell tabs 114) can be connected to the intermediate bus bar 4. By directly connecting the first clip 53 to the respective one of the cell tabs (positive electrode cell tabs 113 and negative electrode cell tabs 114) without contacting the intermediate bus bar 4, the state of the battery cell 11 can be detected with high accuracy without detecting the resistance component of the bus bar. The above connection configuration can be similarly applied to the sub circuit unit 6.

[Circuit Diagram]

FIG. 7 is a circuit diagram of the sensor unit 5, the battery cells 11, the positive electrode bus bar 2, the negative electrode bus bar 3, and the intermediate bus bar 4. As shown in FIG. 7, the battery cell 11 (S1) and the battery cell 11 (S2) are connected in parallel between the positive electrode bus bar 2 and the intermediate bus bar 4.

A positive electrode side (positive electrode cell tab 113) of the battery cell 11 (S1) has the contact (P1) closest to the positive electrode external terminal P in the positive electrode bus bar 2, and a negative electrode side (negative electrode cell tab 114) has the contact (N1) closest to the intermediate external terminal M in the intermediate bus bar 4.

A positive electrode side (positive electrode cell tab 113) of the battery cell 11 (S2) has the contact (P2) farthest from the positive electrode external terminal P in the positive electrode bus bar 2, and a negative electrode side (negative electrode cell tab 114) has the contact (N2) second-closest to the intermediate external terminal M in the intermediate bus bar 4.

The battery cell 11 (S3) and the battery cell 11 (S3) are connected in parallel between the intermediate bus bar 4 and the negative electrode bus bar 3.

A positive electrode side (positive electrode cell tab 113) of the battery cell 11 (S3) has the contact (P3) third-closest to the intermediate external terminal M in the intermediate bus bar 4, and a negative electrode side (negative electrode cell tab 114) has the contact (N3) closest to the negative electrode external terminal N in the negative electrode bus bar 3.

A positive electrode side (positive electrode cell tab 113) of the battery cell 11 (S4) has the contact (P4) farthest from the intermediate external terminal M in the intermediate bus bar 4, and a negative electrode side (negative electrode cell tab 114) has the contact (N4) farthest from the negative electrode external terminal N in the negative electrode bus bar 3.

The sensor circuit 52 is connected to the contact (N1), the contact (N2), the contact (P3), and the contact (P4) by the first clips 53 attached to the sensor case 51.

The sensor circuit 52 is connected to the contact (P1), the contact (P2), the contact (N3), and the contact (N4) by the jumper wires 54 (fourth clips 542).

Accordingly, the sensor circuit 52 can detect a state of the battery cell 11 (S1) from the contact (P1) and the contact (N1), a state of the battery cell 11 (S2) from the contact (P2) and the contact (N2), a state of the battery cell 11 (S3) from the contact (P3) and the contact (N3), and a state of the battery cell 11 (S4) from the contact (P4) and the contact (N4).

[First Modification]

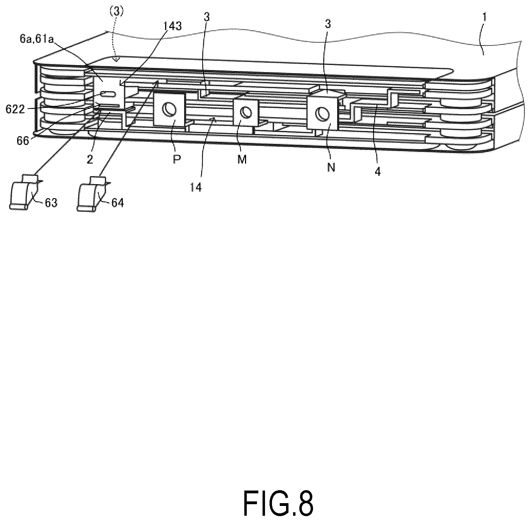

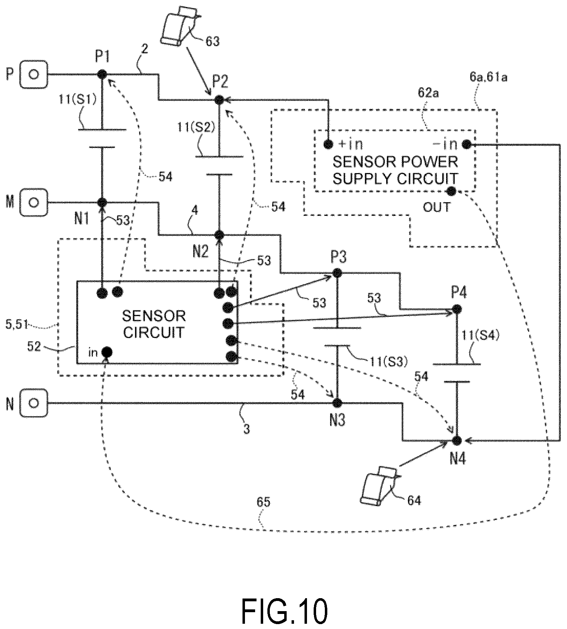

FIG. 8 is a perspective view of a first modification of the battery module according to the present embodiment. FIG. 9A is a plan view of a sensor power supply unit 6a according to the first modification. FIG. 9B is a cross-sectional view before the sensor power supply unit 6a according to the first modification is sandwiched between the positive electrode bus bar 2 and the negative electrode bus bar 3. FIG. 9C is a cross-sectional view after the sensor power supply unit 6a according to the first modification is sandwiched between the positive electrode bus bar 2 and the negative electrode bus bar 3. FIG. 9D is a cross-sectional view when the sensor power supply unit 6a according to the first modification is fixed by a clip (second clip 63 and third clip 64). FIG. 10 is a circuit diagram of the sensor unit 5, the battery cells 11, the positive electrode bus bar 2, the negative electrode bus bar 3, the intermediate bus bar 4, and the sensor power supply unit 6a according to the first modification. In FIG. 8, the sensor unit 5 and the terminal cover 7 are not shown.

When a voltage of the battery cell 11 changes depending on a state-of-charge (SOC) and voltage measurement (AD conversion) value in the sensor circuit 52 varies, the sensor power supply unit 6a can be used for eliminating the variation.

The sensor power supply unit 6a includes the insulating holder 61a sandwiched between the positive electrode bus bar 2 and the negative electrode bus bar 3, the sensor power supply circuit 62a (FIG. 9A) attached to the holder 61a, a first extraction electrode 623 (FIG. 9A) electrically connected to a positive electrode side of the sensor power supply circuit 62a, a second extraction electrode 624 (FIG. 9A) electrically connected to a negative electrode side of the sensor power supply circuit 62a, the second connection terminal 622 connected to an output side of the sensor power supply circuit 62a, the second clip 63, and the third clip 64.

The holder 61a has an L-shape in plan view on a side in contact with the negative electrode bus bar 3 as shown in FIG. 9A, but has a U-shape when viewed from a cross-sectional direction (thickness direction of the laminated cell 1) as shown in FIG. 9B.

The sensor power supply circuit 62a is, for example, a portion extending in the thickness direction of the holder 61a, and is disposed on a back surface of an opposing surface of the terminal cover 7 (FIG. 3). It is efficient to connect positive and negative terminals of the sensor power supply circuit 62a to receive two voltages in series (2.5 V to 4.2 V x 2) as input. Therefore, by mounting the sensor power supply circuit 62a at a position where the sensor power supply circuit 62a can be connected to the positive electrode bus bar 2 and the negative electrode bus bar 3 at the shortest distance, it is possible to shorten lengths of the second clip 63 and the third clip 64 having a plate spring shape, which are connection units (substitute for wiring), and it is advantageous in terms of rigidity during fitting and saving on material costs.

In the battery module shown in FIG. 8, since the negative electrode bus bar 3 is close to an upper space of the positive electrode bus bar 2, if the sensor power supply circuit 62a is mounted in this upper space (second divided space 143 (FIGS. 2 and 9B)), the lengths of the second clip 63 and the third clip 64 can be shortened, which is preferable.

In the connection of the sensor power supply circuit 62a, an effect of bus bar resistance on sensing can be ignored, and thus a connection point of the second clip 63 and the third clip 64 may be a bus bar or a cell tab.

Further, when an upper surface of the holder 61a is in contact with an inner wall (thin plate portion 12) of the accommodation space 14 or the stopper 141, the holder 61a may be fixed by, for example, an elastic sheet, a double-sided tape, or a modified silicone adhesive. This is an effective fixing method for providing vibration resistance when the vehicle is mounted.

A connection mode between the second connection terminal 622 and the first connection terminal 521 (FIG. 3) is the same as the mode shown in FIG. 3, but as shown in FIG. 10, the first connection terminal 521 and the second connection terminal 622 may be omitted, and a power supply output terminal (OUT) of the sensor power supply circuit 62a and a power supply input terminal (IN) of the sensor circuit 52 may be directly connected by a jumper wire 65.

The first extraction electrode 623 is disposed on a back surface of a contact surface of the holder 61a with the positive electrode bus bar 2.

The second extraction electrode 624 is disposed on a back surface of a contact surface of the holder 61a with the negative electrode bus bar 3 and in a portion having a narrow width in a lateral direction of FIG. 9A.

An insertion hole 66 is disposed on a first extraction electrode 623 side of a portion extending in a thickness direction of the holder 61a, and the first extraction electrode 623 is disposed at a position facing the insertion hole 66.

A procedure for attaching the sensor power supply unit 6a is to sandwich the holder 61a between the positive electrode bus bar 2 and the negative electrode bus bar 3, as shown in FIGS. 9B and 9C. Further, as shown in FIGS. 9C and 9D, one arm of the second clip 63 is inserted into the insertion hole 66 and brought into contact with the first extraction electrode 623, and the other arm of the second clip 63 is brought into contact with the positive electrode bus bar 2, whereby the positive electrode bus bar 2, the holder 61a (on the positive electrode bus bar 2 side), and the first extraction electrode 623 are simultaneously sandwiched by the second clip 63. Similarly, as shown in FIGS. 9C and 9D, by bringing one arm of the third clip 64 into contact with the second extraction electrode 624 and bringing the other arm of the third clip 64 into contact with the negative electrode bus bar 3, the negative electrode bus bar 3, the holder 61a (on the negative electrode bus bar 3 side), and the second extraction electrode 624 are simultaneously sandwiched by the third clip 64.

According to the above procedure, the holder 61a (on the positive electrode bus bar 2 side) is fixed to the positive electrode bus bar 2, and the first extraction electrode 623 is electrically connected to the positive electrode bus bar 2 (contact (P2)) via the second clip 63 (FIG. 10). The holder 61a (on the negative electrode bus bar 3 side) is fixed to the negative electrode bus bar 3, and the second extraction electrode 624 is electrically connected to the negative electrode bus bar 3 (contact (N4)) via the third clip 64 (FIG. 10).

A gap between the negative electrode bus bar 3 and an inner wall of the accommodation space 14 is narrow, and when the second extraction electrode 624, the holder 61a, and the negative electrode bus bar 3 (cell tab) are simultaneously sandwiched by the third clip 64, the third clip 64 may interfere with the inner wall of the accommodation space 14 and may be difficult to perform sandwiching. In this case, a tab (not shown) extending from the second extraction electrode 624 may be disposed on the negative electrode bus bar 3, and the tab (not shown) and the negative electrode bus bar 3 (cell tab) may be sandwiched by the third clip 64. Accordingly, since a gap between the tab (not shown) and the inner wall of the accommodation space 14 is increased by an amount of the thickness of the holder 61a being reduced, the third clip 64 can easily clamp the tab.

[Jumper Wire and Clip]

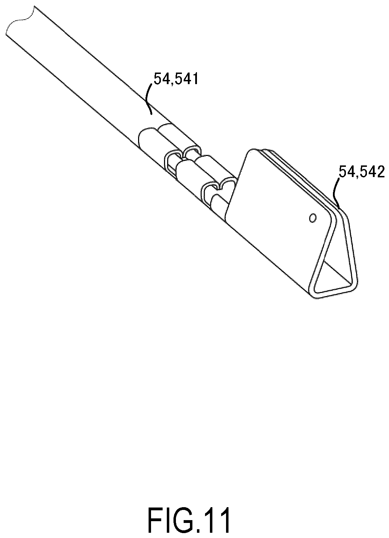

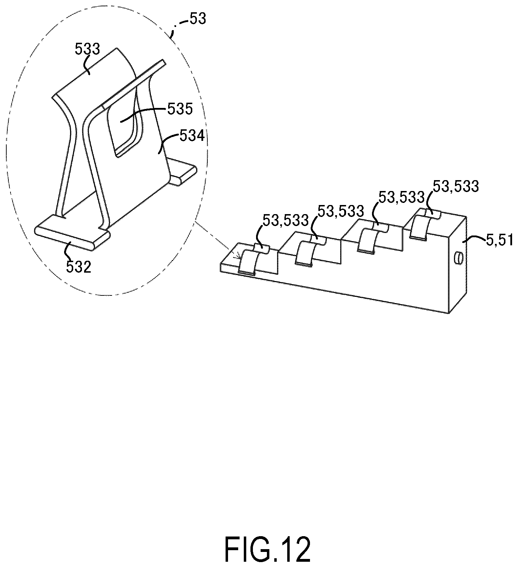

FIG. 11 is a view illustrating an example of the jumper wire 54 extending from the sensor unit 5. FIG. 12 is a view showing an example of a clip (first clip 53) attached to the sensor case 51.

As shown in FIG. 11, the jumper wire 54 includes a flexibly deformable covering wiring 541 and the fourth clip 542 disposed at a tip of the covering wiring 541. The fourth clip 542 is connected to a conductive wire (copper wire) in the covering wiring 541. Further, the fourth clip 542 is set to have a width between two arms slightly smaller than a dimension obtained by adding a thickness of the bus bar and a thickness of the cell tab, and the bus bar and the cell tab can be simultaneously sandwiched between the two arms.

As shown in FIG. 12, the first clip 53 has a structure in which arms 533 and 534 extend from both ends of a base portion 532 in a width direction. The pair of arms 533 and 534 are formed in such a shape that a gap therebetween decreases as distances from the base portion 532 increase, and the gap therebetween increases midway. In the arm 533, a portion where the gap between the arm 533 and the arm 534 is the smallest is a portion where most pressing force is applied to the respective one of the cell tabs (positive electrode cell tabs 113 and negative electrode cell tabs 114) (FIG. 6).

A planar portion 535 is formed at a center of the arm 534 that is in contact with the extraction electrode 522 (FIGS. 5 and 6) and is disposed so as to stand approximately perpendicular to the base portion 532. Accordingly, when the first clip 53 is attached to the sensor case 51, the planar portion 535 comes into surface contact with the extraction electrode 522, so that contact resistance between the extraction electrode 522 (FIGS. 5 and 6) and the first clip 53 can be reduced.

[Second Modification]

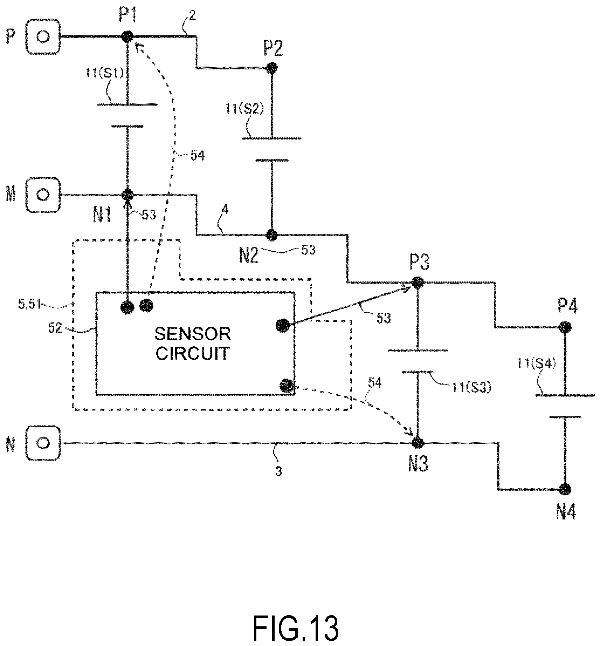

FIG. 13 is a circuit diagram of the sensor unit 5, the battery cells 11, the positive electrode bus bar 2, the negative electrode bus bar 3, and the intermediate bus bar 4 according to a second modification of the battery module of the present embodiment.

The second modification has a configuration for easily measuring apparent internal resistance between the positive electrode external terminal P and the intermediate external terminal M (or the intermediate external terminal M and the negative electrode external terminal N).

In FIG. 13, when resistance between the positive electrode external terminal P and the contact (P1) in the positive electrode bus bar 2 is Rb, resistance between the contact (P1) and the contact (P2) in the positive electrode bus bar 2 is Rb12, resistance between the intermediate external terminal M and the contact (N1) in the intermediate bus bar 4 is Rb, resistance between the contact (N1) and the contact (N2) in the intermediate bus bar 4 is Rb12, internal resistance of the battery cell 11 (S1) is Rc1, and internal resistance of the battery cell 11 (S2) is Rc2, apparent internal resistance Rpm between the positive electrode external terminal P and the intermediate external terminal M is expressed by the following Formula (1).

[Math. 1]

$$\mathrm{Rpm} = \frac{(2Rb+Rc1)*(2(Rb+Rb12)+Rc2)}{(2Rb+Rc1)+(2(Rb+Rb12)+Rc2)} \quad (1)$$

Resistance of a bus bar is sufficiently small with respect to the internal resistance Rc1 of the battery cell 11 (S1) and the internal resistance Rc2 of the battery cell 11 (S2). Therefore, it can be considered that Rb12 << Rc2, and in Formula (1), Rb12 = 0, and Rc2 = Rc1. Accordingly, Formula (1) can be simplified as the following Formula (2).

[Math. 2]

$$\mathrm{Rpm} = \frac{(2Rb+Rc1)}{2} \quad (2)$$

Therefore, in practice, the internal resistance of the parallel-connected battery cells 11 may be detected by connecting the battery cells to one cell.

Assuming that $Rc1 = Rc = 2$, strictly speaking, a larger charge and discharge current flows to the battery cell 11 (S1) closer to the positive electrode external terminal P and the intermediate external terminal M due to a difference in bus bar resistance. Accordingly, in the battery cell 11 (S1) and the battery cell 11 (S2), it is appropriate to connect the sensor circuit 52 to the battery cell 11 (S1) through which a larger charge and discharge current flows in terms of diagnosing a state of health (SOH) of a battery.

Therefore, the internal resistance $Rc1$ of the battery cell 11 (S1) is detected by the sensor circuit 52, and the internal resistance $Rc1$ is applied to Formula (2), whereby combined resistance with the battery cell 11 (S2), that is, the internal resistance $Rpm$ between the positive electrode external terminal P and the intermediate external terminal M can be calculated.

Although the battery cell 11 (S1) and the battery cell 11 (S2) have been described as examples, the present invention can also be applied to the battery cell 11 (S3) and the battery cell 11 (S4) when calculating internal resistance of the battery cell 11 (S3) and the battery cell 11 (S4) viewed from the intermediate external terminal M and the negative electrode external terminal N. That is, the internal resistance of the battery cell 11 (S3) is detected by the sensor circuit 52, and the internal resistance is applied to Formula (2), whereby combined resistance with the battery cell 11 (S4), that is, internal resistance between the intermediate external terminal M and the negative electrode external terminal N can be calculated.

[Effects of Present Embodiment]

The battery module according to the present embodiment includes: the laminated cell 1 in which the plurality of battery cells 11 are laminated; the bus bars (positive electrode bus bar 2, negative electrode bus bar 3, and intermediate bus bar 4) connected to the battery cells 11; and the sensor unit 5 including the sensor circuit 52 that is electrically connected to the bus bars and that measures the state of the battery cells, in which the bus bars (positive electrode bus bar 2, negative electrode bus bar 3, and intermediate bus bar 4) are disposed in the accommodation space 14 formed on one side surface of the laminated cell 1, the sensor unit 5 includes the sensor case 51 accommodating the sensor circuit 52, formed to match the shape of the bus bars (positive electrode bus bar 2, negative electrode bus bar 3, and intermediate bus bar 4), and accommodated in the accommodation space 14 in a manner of being in contact with the bus bars (positive electrode bus bar 2, negative electrode bus bar 3, and intermediate bus bar 4), and fitting portions (first clips 53) electrically connected to the sensor circuit 52, disposed in the sensor case 51 at the positions facing the bus bars (positive electrode bus bar 2, negative electrode bus bar 3, and intermediate bus bar 4) when the sensor case 51 is accommodated in the accommodation space 14 and capable of being fitted to the bus bars (positive electrode bus bar 2, negative electrode bus bar 3, and intermediate bus bar 4), and by fitting the fitting portions (first clips 53) to the bus bars (positive electrode bus bar 2, negative electrode bus bar 3, and intermediate bus bar 4), the sensor case 51 is fixed to the bus bars (positive electrode bus bar 2, negative electrode bus bar 3, and intermediate bus bar 4) and the sensor circuit 52 is electrically connected to the bus bars (positive electrode bus bar 2, negative electrode bus bar 3, and intermediate bus bar 4) via the fitting portions (first clips 53).

According to the above configuration, the sensor case 51 and the fitting portions (first clips 53) serving as the terminals electrically connected to the sensor circuit 52 are integrated, and the fitting portions (first clips 53) are directly connected to the bus bars (positive electrode bus bar 2, negative electrode bus bar 3, intermediate bus bar 4), so that the battery module can be constructed without increasing an outer shape of the battery module and simultaneously reducing a wiring material and the number of work steps. Further, the sensor unit 5 can be mounted without increasing the battery module in the thickness direction by using the accommodation space 14 inevitably generated due to the structure of the bus bars (positive electrode bus bar 2, negative electrode bus bar 3, and intermediate bus bar 4). Further, since a wiring length can be made as short as possible or can be omitted, a short circuit prevention measure at the time of assembly can be easily taken. Further, the same effect can be obtained even in a disassemblying work in the secondary usage or recycling step. As described above, an overall cost reduction effect throughout an entire product life cycle, from the battery manufacturing to the disposal, can be obtained.

The battery cell 11 is configured such that a predetermined surface pressure is applied thereto. This is due to reduced interelectrode resistance and the structure that limits volume expansion that accompanies deterioration. Therefore, a space (gap) in a laminating direction of the battery cells 11 is set to a necessary minimum limit.

In response to this, the sensor circuit 52 mounted on an exterior surface of the battery cell 11 is required to be small and thin, which limits the degree of freedom of selection of parts to be used and manufacturing methods, resulting in high manufacturing costs.

On the other hand, a mounting region for the bus bars (positive electrode bus bar 2, negative electrode bus bar 3, intermediate bus bar 4) has a space at least equal to the thickness of the laminated cell 1, and as long as the bus bars can be accommodated in that space, there is a greater degree of freedom in the design and selection of parts to be used, making it possible to reduce costs.

In addition, electrochemical impedance spectroscopy (EIS) measurement (internal resistance measurement) as a method for knowing an internal state of the battery cell 11 requires precise four-terminal connection corresponding to a measurement range (low internal resistance of the battery cell 11), and for this reason, in the related art (see Patent Document 1), an individual wiring is set on the cell tab of the battery cell 11.

The bus bars (positive electrode bus bar 2, negative electrode bus bar 3, intermediate bus bar 4) are also designed to connect the battery cells 11 at the shortest distance in order to reduce the power loss. Therefore, in the present embodiment, by integrating and attaching the connectors (first clips 53) having the contacts near the connection points of these bus bars (positive electrode bus bar 2, negative electrode bus bar 3, intermediate bus bar 4) and the cell tabs to the sensor case 51 (sensor circuit 52), it is possible to achieve precision measurement similar to those achieved when signal connection of the sensor circuit 52 is connected to the cell tabs by the individual wiring. Accordingly, while maintaining measurement accuracy, a fixing/wiring work of the sensor circuit 52 can be completed in one process, and adhesives/-cohesives that fixes the wiring of the sensor circuit 52 are also unnecessary, which is effective in reducing costs, protecting the environment, and saving resources.

No current is applied to the sensor circuit 52 until the sensor case 51 is attached to the bus bars (positive electrode bus bar 2, negative electrode bus bar 3, and intermediate bus bar 4). Further, by removing the sensor case 51, the power supply to the sensor circuit 52 is cut off. Therefore, a short circuit between positive and negative electrodes of the battery cell 11 (external short circuit of the battery cell 11) via the sensor circuit 52 can be prevented when the sensor case 51 is attached or detached.

Since the sensor circuit 52 can function continuously from the time the sensor circuit 52 is manufactured until the end of the life of a cell, charge and discharge control (deterioration prevention) based on a history of the battery cell 11 becomes possible, and as a result, it becomes possible to reduce the overall cost by fully utilizing a capacity of the battery cell 11.

In the present embodiment, the sensor circuit 52 includes the plurality of divided sensor circuits (sensor circuits 52), the sensor case 51 includes the plurality of divided sensor cases (sensor cases 51) that respectively accommodate the divided sensor circuits 52, and the divided sensor cases (sensor cases 51) are disposed in the accommodation space 14.

According to the above configuration, even when the accommodation space 14 is divided by the bus bars (positive electrode bus bar 2, negative electrode bus bar 3, and intermediate bus bar 4) finely, the sensor unit 5 (sensor circuit 52) is divided into the plurality of divided sensor units, the divided sensor cases (sensor cases 51) as many as the divided sensor units 5 are prepared, and the divided sensor circuits (sensor circuits 52) are accommodated in the respective divided sensor cases (sensor cases 51) and are disposed in the accommodation space 14. Accordingly, even if the plurality of divided sensor cases (sensor cases 51) are present, the divided sensor cases each having a small size are provided in the accommodation space 14, and thus the divided sensor cases can be disposed so as not to interfere with the bus bars, and the degree of freedom in designing the battery module can be increased.

In the present embodiment, the bus bars (positive electrode bus bar 2, negative electrode bus bar 3, and intermediate bus bar 4) include the positive electrode bus bar 2, the negative electrode bus bar 3, and the intermediate bus bar 4, the battery cells 11 include first battery cells (battery cell 11 (S1) and battery cell 11 (S2)) electrically connecting the positive electrode bus bar 2 and the intermediate bus bar 4, and second battery cells (battery cell 11 (S3) and battery cell 11 (S4)) electrically connecting the intermediate bus bar 4 and the negative electrode bus bar 3, the sensor case 51 is formed to match the shape of the intermediate bus bar 4, and the plurality of fitting portions (first clips 53) are disposed so as to respectively face connection positions of the intermediate bus bar 4 with the first battery cells (battery cell 11 (S1) and battery cell 11 (S2) and connection positions of the intermediate bus bar 4 with the second battery cells (battery cell 11 (S3) and battery cell 11 (S4)) when the sensor case 51 is accommodated in the accommodation space 14.

With the above configuration, the battery module can be easily constructed by disposing the sensor case 51 in the space partitioned between the intermediate bus bar 4 and the inner wall of the accommodation space 14, which has a large excess space due to the structure of the battery module. Here, since the intermediate bus bar 4 brings together the contacts (N1, N2, P3, P4) with the first battery cells (battery cell 11 (S1) and battery cell 11 (S2)) and the second battery cells (battery cell 11 (S3) and battery cell 11 (S4)), a length of a contact electrode having a plate spring shape, which is a connection unit (substitute for wiring) between the sensor circuit 52 and the cell tab, can be shortened (which is advantageous in terms of rigidity during fitting and saving on material costs). Further, supporting and fixing the sensor circuit 52 at a plurality of points (four points in the present embodiment) also makes it advantageous for a vibration-resistant design (strength required to fix the sensor circuit 52 and the degree of freedom in designing support points are obtained). Furthermore, a lower surface of the sensor case 51 is in contact with the thin plate portion 12 or the stopper 141, and may be fixed thereto by, for example, an elastic sheet, a double-sided tape, or a modified silicone adhesive. This is an effective fixing method for providing the vibration resistance when the vehicle is mounted.

In the present embodiment, each of the fitting portions (first clips 53) has a clip shape that simultaneously sandwiches the sensor case 51 and the bus bars (positive electrode bus bar 2, negative electrode bus bar 3, and intermediate bus bar 4).

With the above configuration, the present embodiment can be easily attached and detached and can be achieved at low cost. Further, since it is easy to manage the electrical connection points, by excluding resistance components of the bus bars (positive electrode bus bar 2, negative electrode bus bar 3, intermediate bus bar 4) and the like which are unrelated to the internal state (internal resistance) of the battery cell 11, from sensing targets, it becomes possible to precisely detect (monitor) the internal state of the battery cell 11.

In the present embodiment, the sensor case 51 is formed of the electrically insulating material having the magnetic action.

According to the above configuration, since the inside of the sensor case 51 is electrostatically shielded from the outside, electromagnetic induction noise to the sensor circuit 52 can be reduced even if the sensor circuit 52 is disposed near the bus bars.

In the present embodiment, the positive electrode bus bar 2 includes the positive electrode external terminal P connected to the outside, the negative electrode bus bar 3 includes the negative electrode external terminal N connected to the outside, the plurality of first battery cells (battery cell 11 (S1) and battery cell 11 (S2)) are connected in parallel between the positive electrode bus bar 2 and the intermediate bus bar 4, the plurality of second battery cells (battery cell 11 (S3) and battery cell 11 (S4)) are connected in parallel between the intermediate bus bar 4 and the negative electrode bus bar 3, and when the sensor case 51 is accommodated in the accommodation space 14, the fitting portions (first clips 53) are disposed so as to respectively face a connection position (contact (N1)) between the intermediate bus bar 4 and the first battery cell (battery cell 11 (S1)) connected to a position electrically closest to the positive electrode external terminal P in the first battery cells (battery cell 11 (S1) and battery cell 11 (S2)) in the sensor case 51, and a connection position (contact (P3)) between the intermediate bus bar 4 and the second battery cell (battery cell 11 (S3)) connected to a position electrically closest to the negative electrode external terminal N in the second battery cells (battery cell 11 (S3) and battery cell 11 (S4) in the sensor case 51.

According to the above configuration, since the internal state of the battery cell 11 can be detected in a practically effective manner even if the number of connection points with the battery cell 11 is reduced, the state of the battery cell 11 can be detected more easily and inexpensively.

In the present embodiment, the battery cell 11 includes the power storage unit 111 and the tab cells (positive electrode cell tab 113 and negative electrode cell tab 114) extending from the power storage unit 111 and connected to the bus bars (positive electrode bus bar 2, negative electrode bus bar 3, and intermediate bus bar 4), and the fitting portions (first clips 53) are fitted into the bus bars (positive electrode bus bar 2, negative electrode bus bar 3, and intermediate bus bar 4) so as to sandwich the tab cells (positive electrode cell tab 113 and negative electrode cell tab 114) together with the bus bars (positive electrode bus bar 2, negative electrode bus bar 3, and intermediate bus bar 4).

According to the above configuration, since the fitting portions (first clips 53) do not contact the bus bars (positive electrode bus bar 2, negative electrode bus bar 3, and intermediate bus bar 4), the sensor circuit 52 does not sense the resistance components of the bus bars, and the state of the battery cell 11 can be detected with high accuracy.

The present embodiment further includes: the cover (terminal cover 7) fitted into the laminated cell 1 so as to cover the accommodation space 14; the wiring (fourth wiring 74) disposed on an inner wall of the cover (terminal cover 7); and a power supply unit (sensor power supply unit 6a) including a power supply circuit (sensor power supply circuit 62a) that supplies the power to the sensor unit 5, in which the plurality of divided spaces are formed in the accommodation space 14 by the bus bars (positive electrode bus bar 2, negative electrode bus bar 3, and intermediate bus bar 4), the sensor unit 5 is accommodated in the first divided space 142 formed by the intermediate bus bar 4 among the divided spaces, the power supply input terminal (first connection terminal 521) electrically connected to the sensor circuit 52 is disposed on a surface of the sensor case 51 which faces the cover (terminal cover 7), the power supply unit (sensor power supply unit 6a) includes the holder 61a to which the power supply circuit (sensor power supply circuit 62a) is attached and which is accommodated in the second divided space 143 formed between the positive electrode bus bar 2 and the negative electrode bus bar 3 among the divided spaces, a second fitting portion (second clip 63) electrically connected to an input side (positive side) of the power supply circuit (sensor power supply circuit 62a), disposed at a position of the holder 61a which faces the positive electrode bus bar 2 when the holder 61a is accommodated in the second divided space 143, and capable of being fitted into the positive electrode bus bar 2, a third fitting portion (third clip 64) electrically connected to the input side (negative side) of the power supply circuit (sensor power supply circuit 62a), disposed at a position of the holder 61a which faces the negative electrode bus bar 3 when the holder 61a is accommodated in the second divided space 143, and capable of being fitted into the negative electrode bus bar 3, and a power supply output terminal (second connection terminal 622) electrically connected to an output side of the power supply circuit (sensor power supply circuit 62a) and disposed at a position of the holder 61a which faces the cover (terminal cover 7), by fitting the second fitting portion (second clip 63) into the positive electrode bus bar 2, the holder 61a is fixed to the positive electrode bus bar 2, and the power supply circuit (sensor power supply circuit 62a) is electrically connected to the positive electrode bus bar 2 via the second fitting portion (second clip 63), by fitting the third fitting portion (third clip 64) into the negative electrode bus bar 3, the holder 61a is fixed to the negative electrode bus bar 3, and the power supply circuit (sensor power supply circuit 62a) is electrically connected to the negative electrode bus bar 3 via the third fitting portion (third clip 64), and by fitting the cover (terminal cover 7) into the laminated cell 1, the wiring (fourth wiring 74) simultaneously comes into contact with the power supply output terminal (second connection terminal 622) and the power supply input terminal (first connection terminal 521), and the power supply output terminal (second connection terminal 622) is electrically connected to the power supply input terminal (first connection terminal 521) via the wiring (fourth wiring 74).

The present embodiment further includes: the cover (terminal cover 7) fitted into the laminated cell 1 so as to cover the accommodation space 14; the first wiring 72 and the second wiring 73 disposed on an inner wall of the cover (terminal cover 7); the third wiring 131 disposed on an outer wall of the accommodation space 14 in contact with the cover (terminal cover 7); and a power supply unit (sensor power supply unit 6a) including a power supply circuit (sensor power supply circuit 62a) that supplies the power to the sensor unit 5, in which the plurality of divided spaces are formed in the accommodation space 14 by the bus bars (positive electrode bus bar 2, negative electrode bus bar 3, and intermediate bus bar 4), the sensor unit 5 is accommodated in the first divided space 142 formed by the intermediate bus bar 4 among the divided spaces, the power supply input terminal (first connection terminal 521) electrically connected to the sensor circuit 52 is disposed on a surface of the sensor case 51 which faces the cover (terminal cover 7), the power supply unit (sensor power supply unit 6a) includes the holder 61a to which the power supply circuit (sensor power supply circuit 62a) is attached and which is accommodated in the second divided space 143 formed between the positive electrode bus bar 2 and the negative electrode bus bar 3 among the divided spaces, a second fitting portion (second clip 63) electrically connected to an input side (positive side) of the power supply circuit (sensor power supply circuit 62a), disposed at a position of the holder 61a which faces the positive electrode bus bar 2 when the holder 61a is accommodated in the second divided space 143, and capable of being fitted into the positive electrode bus bar 2, a third fitting portion (third clip 64) electrically connected to the input side (negative side) of the power supply circuit (sensor power supply circuit 62a), disposed at a position of the holder 61a which faces the negative electrode bus bar 3 when the holder 61a is accommodated in the second divided space 143, and capable of being fitted into the negative electrode bus bar 3, and a power supply output terminal (second connection terminal 622) electrically connected to an output side of the power supply circuit (sensor power supply circuit 62a) and disposed at a position of the holder 61a which faces the cover (terminal cover 7), by fitting the second fitting portion (second clip 63) into the positive electrode bus bar 2, the holder 61a is fixed to the positive electrode bus bar 2, and the power supply circuit (sensor power supply circuit 62a) is electrically connected to the positive electrode bus bar 2 via the second fitting portion (second clip 63), by fitting the third fitting portion (third clip 64) into the negative electrode bus bar 3, the holder 61a is fixed to the negative electrode bus bar 3, and the power supply circuit (sensor power supply circuit 62a) is electrically connected to the negative electrode bus bar 3 via the third fitting portion (third clip 64), and by fitting the cover (terminal cover 7) into the laminated cell 1, the first wiring 72 simultaneously come into contact with the power supply output terminal (second connection terminal 622) and the third wiring 131, and the second wiring 73 simultaneously comes into contact with the power supply input terminal (first connection terminal 521) and the third wiring 131, whereby the power supply output terminal (second connection terminal 622) is electrically connected to the power supply input terminal (first connection terminal 521) via the first wiring 72, the second wiring 73, and the third wiring 131.

With the above configuration, no current is applied to the power supply circuit (sensor power supply circuit 62a) until the power supply unit (sensor power supply unit 6a) is attached to the positive electrode bus bar 2 and the negative electrode bus bar 3. Further, by removing the power supply unit (sensor power supply unit 6a) from the positive electrode bus bar 2 or the negative electrode bus bar 3, the power supply to the power supply circuit (sensor power supply circuit 62a) is cut off. Therefore, a short circuit between the positive and negative electrodes of the battery cell 11 (external short circuit of the battery cell 11) via the power supply circuit (sensor power supply circuit 62a) can be prevented when the power supply circuit (sensor power supply circuit 62a) is attached or detached.

According to the above configuration, no current is applied to the sensor circuit 52 until the cover (terminal cover 7) is attached to the laminated cell 1. Further, by removing the cover (terminal cover 7) from the laminated cell 1, the power supply to the sensor circuit 52 is cut off. Therefore, a short circuit between the positive and negative electrodes of the battery cell 11 (external short circuit of the battery cell 11) via the cover (terminal cover 7) including the wiring (first wiring 72 and second wiring 73, or fourth wiring 74) can be prevented when the cover (terminal cover 7) is attached or detached.

In the present embodiment, the laminated cell 1 includes the pair of fastening portions 112 that fasten the plurality of battery cells 11 together, and the fastening portions 112 are disposed at both ends of at least one side surface of the laminated cell 1, and the accommodation space 14 is disposed between the pair of fastening portions 112.

With the above configuration, since the accommodation space 14 is disposed in an existing space inside an outer shape of the laminated cell 1, the sensor unit 5 and the like disposed in the accommodation space 14 can be protected.

Although the embodiments of the present invention have been described above, the above embodiments merely exemplify some of application examples of the present invention and do not intend to limit the technical scope of the present invention to the specific configurations of the above embodiments. The above embodiments can be combined as appropriate.

The present application claims priority under Japanese Patent Application No. 2022-085496 filed to the Japan Patent Office on May 25, 2022, and the entire content of this application is incorporated herein by reference.

**Claims**

1. A battery module comprising:

a laminated cell in which a plurality of battery cells are laminated;
a bus bar connected to the battery cells; and
a sensor unit including a sensor circuit that is electrically connected to the bus bar and that measures a state of the battery cells, wherein
the bus bar is disposed in an accommodation space formed on one side surface of the laminated cell,
the sensor unit includes

a sensor case accommodating the sensor circuit, formed to match a shape of the bus bar, and accommodated in the accommodation space in a manner of being in contact with the bus bar, and
a fitting portion electrically connected to the sensor circuit, disposed at a position facing the bus bar in the sensor case when the sensor case is accommodated in the accommodation space, and capable of being fitted to the bus bar, and

by fitting the fitting portion to the bus bar, the sensor case is fixed to the bus bar, and the sensor circuit is electrically connected to the bus bar via the fitting portion.

2. The battery module according to claim 1, wherein
the sensor circuit includes a plurality of divided sensor circuits, the sensor case includes a plurality of divided sensor cases that respectively accommodate the divided sensor circuits, and the sensor case is disposed in the accommodation space.

3. The battery module according to claim 1, wherein

the bus bar includes a positive electrode bus bar, a negative electrode bus bar, and an intermediate bus bar, the battery cells include

a first battery cell electrically connecting the positive electrode bus bar and the intermediate bus bar, and
a second battery cell electrically connecting the intermediate bus bar and the negative electrode bus bar,

the sensor case is formed to match a shape of the intermediate bus bar, and
a plurality of the fitting portions are disposed so as to respectively face a connection position of the intermediate bus bar with the first battery cell and a connection position of the intermediate bus bar with the second battery cell when the sensor case is accommodated in the accommodation space.

4. The battery module according to any one of claims 1 to 3, wherein
the fitting portion has a clip shape that simultaneously sandwiches the sensor case and the bus bar.

5. The battery module according to claim 1, wherein
the sensor case is formed of an electrically insulating material having a magnetic action.

6. The battery module according to claim 3, wherein

the positive electrode bus bar includes a positive electrode external terminal connected to an outside,
the negative electrode bus bar includes a negative electrode external terminal connected to the outside,
a plurality of the first battery cells are connected in parallel between the positive electrode bus bar and the intermediate bus bar,
a plurality of the second battery cells are connected in parallel between the intermediate bus bar and the negative electrode bus bar, and
the fitting portions are disposed so as to respectively face a connection position between the intermediate bus bar and the first battery cell which is connected to a position electrically closest to the positive electrode external terminal among the first battery cells in the sensor case, and a connection position between the intermediate bus bar and the second battery cell which is connected to a position electrically closest to the negative electrode external terminal among the second battery cells in the sensor case when the sensor case is accommodated in the accommodation space.

7. The battery module according to claim 1, wherein

each of the battery cells includes a power storage unit and a tab cell extending from the power storage unit and connected to the bus bar, and
the fitting portion is fitted to the bus bar so as to sandwich the tab cell together with the bus bar.

8. The battery module according to claim 3, further comprising:

a cover fitted into the laminated cell so as to cover the accommodation space;
a first wiring and a second wiring disposed on an inner wall of the cover;
a third wiring disposed on an outer wall of the accommodation space in contact with the cover; and
a power supply unit including a power supply circuit that supplies power to the sensor unit, wherein
a plurality of divided spaces are formed in the accommodation space by the bus bar,
the sensor unit is accommodated in a first divided space formed by the intermediate bus bar among the divided spaces,
a power supply input terminal electrically connected to the sensor circuit is disposed on a surface of the sensor case which faces the cover,
the power supply unit includes

a holder to which the power supply circuit is attached and which is accommodated in a second divided space formed between the positive electrode bus bar and the negative electrode bus bar among the divided spaces,
a second fitting portion electrically connected to an input side of the power supply circuit, disposed at a position of the holder which faces the positive electrode bus bar when the holder is accommodated in the second divided space, and capable of being fitted to the positive electrode bus bar,
a third fitting portion electrically connected to the input side of the power supply circuit, disposed at a position of the holder which faces the negative electrode bus bar when the holder is accommodated in the second divided space, and capable of being fitted to the negative electrode bus bar, and
a power supply output terminal electrically connected to an output side of the power supply circuit and disposed at a position of the holder which faces the cover,

by fitting the second fitting portion to the positive electrode bus bar, the holder is fixed to the positive electrode bus bar, and the power supply circuit is electrically connected to the positive electrode bus bar via the second fitting portion,
by fitting the third fitting portion to the negative electrode bus bar, the holder is fixed to the negative electrode bus bar, and the power supply circuit is electrically connected to the negative electrode bus bar via the third fitting portion, and
by fitting the cover into the laminated cell, the first wiring simultaneously comes into contact with the power supply output terminal and the third wiring, and the second wiring simultaneously comes into contact with the power supply input terminal and the third wiring, whereby the power supply output terminal is electrically connected to the power supply input terminal via the first wiring, the second wiring, and the third wiring.

9. The battery module according to claim 1, wherein

the laminated cell includes a pair of fastening portions that fasten the plurality of battery cells together, and the fastening portions are disposed on both ends of at least one side surface of the laminated cell, and
the accommodation space is disposed between the pair of fastening portions.

FIG.1

FIG.2

FIG.3

FIG.4A

FIG.4B

FIG.5

FIG.6

FIG.7

FIG.8

FIG.9A

FIG.9B

64

6a,61a

3

624

622

62a

66

623

63

2

FIG.9C

FIG.9D

FIG.10

FIG.11

FIG.12

FIG.13

## INTERNATIONAL SEARCH REPORT

International application No.

**PCT/IB2023/000279**

### A. CLASSIFICATION OF SUBJECT MATTER

*H01M 50/569*(2021.01)i; *H01M 10/48*(2006.01)i; *H01M 50/211*(2021.01)i; *H01M 50/296*(2021.01)i;
*H01M 50/298*(2021.01)i; *H01M 50/50*(2021.01)i; *H01M 50/505*(2021.01)i; *H02J 7/00*(2006.01)i
FI:  H01M50/569; H01M50/211; H01M50/298; H01M50/505; H01M50/50 101; H01M10/48 P; H01M50/296; H02J7/00
301A

According to International Patent Classification (IPC) or to both national classification and IPC

### B. FIELDS SEARCHED

Minimum documentation searched (classification system followed by classification symbols)

H01M50/569; H01M10/48; H01M50/211; H01M50/296; H01M50/298; H01M50/50; H01M50/505; H02J7/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2014/010419 A1 (NISSAN MOTOR CO., LTD.) 16 January 2014 (2014-01-16) | 1-9 |
| A | JP 2011-049080 A (NISSAN MOTOR CO., LTD.) 10 March 2011 (2011-03-10) | 1-9 |
| A | JP 2009-231267 A (NISSAN MOTOR CO., LTD.) 08 October 2009 (2009-10-08) paragraphs [0019]-[0021], [0060], fig. 4, 5, 25 | 1-9 |
| A | JP 2008-117626 A (NISSAN MOTOR CO., LTD.) 22 May 2008 (2008-05-22) | 1-9 |
| A | JP 2013-525945 A (LG CHEM, LTD.) 20 June 2013 (2013-06-20) | 1-9 |
| A | CN 113921995 A (FARASIS ENERGY (GANZHOU) CO., LTD.) 11 January 2022 (2022-01-11) | 1-9 |

☐ Further documents are listed in the continuation of Box C.     ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **18 August 2023** | **29 August 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/IB2023/000279**

| Patent document cited in search report | | | Publication date (day/month/year) | Patent family member(s) | | | Publication date (day/month/year) |
|---|---|---|---|---|---|---|---|
| WO | 2014/010419 | A1 | 16 January 2014 | US | 2015/0171488 | A1 | |
| | | | | EP | 2874204 | A1 | |
| | | | | KR | 10-2015-0007354 | A | |
| | | | | CN | 104396049 | A | |
| JP | 2011-049080 | A | 10 March 2011 | US | 2012/0141847 | A1 | |
| | | | | WO | 2011/024574 | A1 | |
| | | | | EP | 2472635 | A1 | |
| | | | | CN | 102473879 | A | |
| | | | | KR | 10-2012-0048631 | A | |
| JP | 2009-231267 | A | 08 October 2009 | US | 2011/0014512 | A1 | |
| | | | | paragraphs [0046]-[0049], fig. 4, 5, 25 | | | |
| | | | | WO | 2009/107657 | A1 | |
| | | | | EP | 2262040 | A1 | |
| | | | | KR | 10-2010-0111307 | A | |
| | | | | CN | 101960647 | A | |
| JP | 2008-117626 | A | 22 May 2008 | (Family: none) | | | |
| JP | 2013-525945 | A | 20 June 2013 | US | 2012/0315522 | A1 | |
| | | | | WO | 2011/126314 | A2 | |
| | | | | EP | 2538230 | A2 | |
| | | | | KR | 10-2011-0112896 | A | |
| | | | | CN | 102822687 | A | |
| CN | 113921995 | A | 11 January 2022 | (Family: none) | | | |

Form PCT/ISA/210 (patent family annex) (January 2015)

# EP 4 535 551 A1

**REFERENCES CITED IN THE DESCRIPTION**

**Patent documents cited in the description**

- JP 2021018133 A
- JP 2022085496 A